(19) **Europäisches Patentamt**
**European Patent Office**
**Office européen des brevets**

(11) **EP 3 602 724 B1**

(12) **EUROPEAN PATENT SPECIFICATION**

(45) Date of publication and mention
of the grant of the patent:
**09.11.2022   Bulletin 2022/45**

(21) Application number: **17903707.2**

(22) Date of filing: **29.03.2017**

(51) International Patent Classification (IPC):
**H02J 7/00** $^{(2006.01)}$     **H01M 10/44** $^{(2006.01)}$
**G01R 31/36** $^{(2020.01)}$

(52) Cooperative Patent Classification (CPC):
**G01R 31/392; H02J 7/0048; H02J 7/005;**
**H02J 7/007182; H02J 7/04;** H02J 7/00712

(86) International application number:
**PCT/US2017/024827**

(87) International publication number:
**WO 2018/182600 (04.10.2018 Gazette 2018/40)**

(54) **CONTROLLING A BATTERY CHARGE LEVEL**

KONTROLLE DES LADEZUSTANDES EINER BATTERIE

COMMANDE D'UN NIVEAU DE CHARGE DE BATTERIE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**05.02.2020   Bulletin 2020/06**

(73) Proprietor: **INTEL Corporation**
**Santa Clara, CA 95054 (US)**

(72) Inventors:
• **MATSUMURA, Naoki**
**San Jose, CA 95118 (US)**
• **NGUYEN, Don**
**Portland, OR 97231 (US)**

• **KOMOROWSKI, Jason**
**Portland**
**97229 (US)**

(74) Representative: **HGF**
**HGF Limited**
**1 City Walk**
**Leeds LS11 9DX (GB)**

(56) References cited:
**WO-A1-2014/098875     WO-A1-2016/126268**
**WO-A1-2016/189832     US-A1- 2005 052 810**
**US-A1- 2005 052 810     US-A1- 2006 049 805**
**US-A1- 2008 077 338     US-A1- 2011 193 528**
**US-A1- 2013 038 292     US-A1- 2016 266 979**

## Description

### Technical Field

Embodiments described herein generally relate to battery charging. More particularly, embodiments relate to controlling a charge level of a battery to perform a calibration of battery charge capacity.

### Background

It is known that as a number of charge cycles encountered by a battery increases, a full charge capacity of the battery typically decreases. Batteries such as rechargeable batteries may be used as backup batteries for electronic devices such as servers. When these batteries are used as persistent power supplies they are likely to be deployed fully charged and battery replacement is often recommended when the battery is degraded to a capacity of, for example, 80% of the capacity of a fresh battery. To determine when the capacity has degraded to a point where battery replacement is appropriate may require calibration of the battery. Conventionally this calibration may be performed by completely discharging the battery and measuring the actual full battery capacity of the potentially degraded battery from parameters of the discharge. However, the battery discharge potentially compromises the available "backup time" at least during the calibration period. The backup time may be a time for which a certain power is available to an associated electronic device to compensate for any interruption to a primary power source. If the calibration is not performed then replacement of the degraded battery could be performed later than advisable due to overestimating an available full battery capacity.

Reducing an operational charge level of the battery below 100% may extend battery longevity because a lower voltage is associated with the reduced operating charge level and this causes less damage to the battery. A battery may be deployed at less than 100% operational charge level in an electronic device. The lower the operational charge level, the greater the longevity extension that might be expected of the battery. However, some electronic devices may have a minimum energy requirement of the associated battery, so that an operational charge level set for a fresh battery may become insufficient as the full battery capacity diminishes over the life of the battery. Similarly to the case for batteries deployed at or close to full charge, the calibration, performed by completely discharging the battery may compromise functionality of the associated electronic device.

Examples of electronic devices in which rechargeable batteries can be deployed include, but are not limited to, uninterruptible power supplies, electric vehicles, robots, drones and servers.

WO 2016/189832 A1 describes a method for reducing the time required for calculating a full charge capacity, where the method comprises charging a storage battery from a first charging mode from the discharge end voltage to a first charge voltage, charging the storage battery in a second charging mode at the first charge voltage, charging the storage battery in the first charging mode from the first charge voltage to a second charge voltage, and charging the storage battery in the second charging mode at the second charge voltage.

### Brief Description of the Drawings

Embodiments described herein are illustrated by way of example, and not by way of limitation, in the figures of the accompanying drawings in which like reference numerals refer to similar elements:

Figure 1 schematically illustrates an apparatus comprising a rechargeable battery having a fuel gauge integrated circuit comprising charge level control circuitry according to the present technique;

Figure 2 schematically illustrates an architecture of the charge level control circuitry of the apparatus of Figure 1;

Figure 3 schematically illustrates a graph of battery voltage against remaining battery life by percentage, which represents a characteristic function likely to be invariable over a battery lifetime;

Figure 4 schematically illustrates the characteristic function of Figure 3 showing a data point for a given target charge level and a corresponding measured battery voltage;

Figure 5 is a graph schematically illustrating the characteristic function of Figure 3 and Figure 4, but additionally showing two different calibration points; and

Figure 6 is a flowchart that schematically illustrates a calibration method according to the present technique.

**Description of Embodiments**

Illustrative embodiments of the present disclosure include, but are not limited to, methods, systems, apparatuses and machine readable instructions for controlling a charge level of a battery to perform a calibration of battery charge capacity.

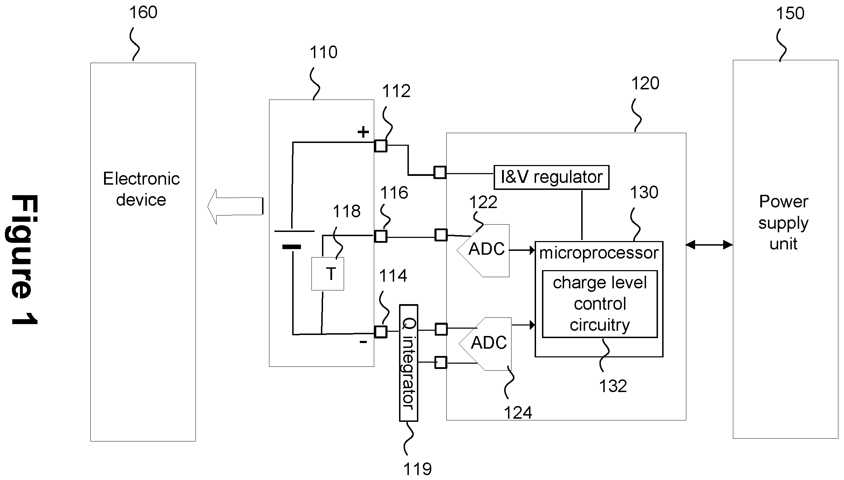

Figure 1 schematically illustrates a battery operated system comprising a battery 1 10, a fuel gauge integrated circuit 120, a power supply unit 150 and an electronic device 160. The electronic device may be, for example, a server apparatus for which the battery 110 is to supply power. The battery may be a "backup battery", which is not the operational power source of the electronic device 160 under normal operating conditions, but instead stores sufficient energy to provide for safe shutdown of the electronic components in the event of a mains power failure or to provide sufficient power for a data backup to be performed. The battery 1 10 is a rechargeable battery such as a Lithium ion (Li ion) battery, which may be recharged via the power supply unit 150 under control of one or more microprocessor(s) 130 provided on the fuel gauge IC 120.

The battery 110 has a positive terminal 112, a negative terminal 114 and a sensor output terminal 116, which feeds one or more battery operating parameters such as a battery temperature, a battery impedance and a peak battery power to a set of charge level control circuitry 132 in the microprocessor. In the Figure 1 example, a temperature sensor 118 is arranged to read a temperature of the battery 110. The fuel gauge integrated circuit 120 comprises, in addition to the microprocessor 130 having the charge level control circuitry 132, a first analogue-to-digital converter (ADC) 122 to convert incoming analogue data from the temperature sensor 118 to a digital format prior to supplying the data to the microprocessor 130. A second ADC 124 converts incoming analogue data from a current integrator 119 into a digital format.

The current integrator 119 is an electronic device performing a time integration of an electric current, thus measuring a total electric charge passing through it. The current integrator 119 may be, for example, a sense resistor or a coulomb gauge or equivalent and its function is to monitor a total quantity of charge supplied to the battery 110 in a charge cycle (or received from the battery in a discharge cycle) in a period of time, such as a time period corresponding to a charging interval or a discharging interval. This may be calculated, for example by calculating a total quantity of charge Q in Coulombs as $Q = I \times t$, where I is a charging current, for example a constant charging current, and t is a time interval in seconds during which the charging current was supplied to the battery 110 to perform charging. Ohms law: $V = I \times R$, may be used to convert between current and voltage measurements. Alternatively, the current integrator 119 may measure a total electric charge passing out of the battery during a discharge or partial discharge. The charge level control circuitry 132 may be arranged to measure an open circuit voltage or a closed circuit voltage using the positive battery terminal 112.

The fuel gauge IC 120 has a current and voltage (I&V) regulator 134, which performs at least one of current or voltage regulation when power originating from the power supply unit 150 is supplied to the battery 110 during a controlled charge of the battery 110 to a calibration charge level. The current and voltage regulator 134 may also or alternatively be arranged to control current and voltage during a discharge of the battery 110 from a calibration charge level to a lower charge level. The charging or discharging of the battery 110 performed by the charge level control circuitry 132 may be a partial charge or a partial discharge, for example, at least a 10% charge or at least a 10% discharge. An accuracy of the calibration may be adequate for a 10% charge or discharge, although a higher percentage could, in some examples, provide an improved level of calibration accuracy, if appropriate.

The charge level of the battery 110 may be measured in dimensioned units such as Coulombs or Ampere Hours (Ah), where 1 Ah is equivalent to 3600 Coulombs. An energy requirement of the battery 110 demanded by the electronic device 160 may be measured in a unit such as Watt Hours (Wh), where 1Wh is equivalent to 3600 Joules. The current integrator 119 may measure a total charge amount supplied to the battery 110 from the power supply unit 150 during a battery charging time interval. Alternatively, the current integrator 119 may measure charge flowing out of the battery during a discharging of the battery 110 in a given time interval.

Deterioration of the battery may occur as a result of multiple charge-discharge cycles and this may cause a reduction in the full battery capacity over time during the battery lifetime. Thus a full capacity specified by a manufacturer, for example, for a new battery is likely to decline in use. As a result, where a battery capacity is expressed in a dimensionless unit such as a percentage charge level, a total energy stored in the battery 110 at the beginning of its deployment when it registers 100% charge on the fuel gauge 120 is likely to be less than a total energy that can be stored in the battery several years later after multiple charging and discharging cycles gauge IC 120. To address this, it is appropriate to perform a battery calibration to provide an accurate estimate of the full battery capacity available at a given time.

Previously known systems might keep the battery at full or close to full charge capacity and periodically initiate a calibration by performing a controlled discharge of the battery and by measuring the charge passing through the battery upon full discharge. However, discharging the battery to a low or negligible charge level to perform the calibration could mean that having power available to the electronic device 160 from the battery 110, such as backup power, should it be needed, is compromised for an extended period of time. For example, it may take several hours to fully discharge the battery and several hours to charge the battery as part of a calibration cycle. The effectiveness of the battery 110 as deployed in the electronic device could be improved by providing a calibration system that reduces this downtime.

The charge level control circuitry 132 according to the present technique may be implemented in the microprocessor 130 as general purpose or special purpose processing hardware, machine-readable instructions, firmware or a combination thereof. It allows for a reduction in calibration downtime by keeping a charge level of the battery 110 to at least a target charge level sufficient to at least meet an energy requirement of the electronic device, for example, a minimum backup energy requirement to facilitate safe shutdown. In one example, the target charge level may be 60% of full charge. The target charge level may be calculated depending upon power requirements, for example in Watts (W), of the electronic device 160 and a target running time to be sustained by the battery 110 to give an energy requirement in Wh. Maintaining the battery 110 at the target charge level between calibration events instead of at a full or higher charge level can increase the longevity of the battery by reducing damage to the battery chemistry than can be caused by charging the battery up to or close to full charge. In cases where it is appropriate to maintain the battery 110 at a level closer to 100% capacity between calibrations, when a calibration is performed, the battery may be discharged to a value no less than the target charge level, which makes it less likely that the battery fails to meet the device energy requirement as a result of the calibration.

The charge level control circuitry 132 performs a battery calibration by transitioning the charge level of the battery 110 between the target charge level and a calibration charge level and determining the effects of supplying power to elevate the charge level (charging cycle) or reduce the charge level (discharge cycle) on at least one electrical parameter of the battery. The target charge level and the calibration charge level may define a range within which a change in charge level of the battery between two levels inside the range is made to perform a full-charge calibration. Longevity of the battery may be extended by keeping the calibration charge level below a full charge level, for example, at or below 90% of a full charge level. However, during calibration, the battery need not be kept at the higher charge level for very long, which means that damage to the battery is less likely. The charge level control circuitry 132 in the example of Figure 1 is provided on a fuel gauge IC, but in some alternative examples, it could be provided as a separate component and in other alternative examples it may be provided together with the battery as part of a battery assembly such as a backup battery assembly.

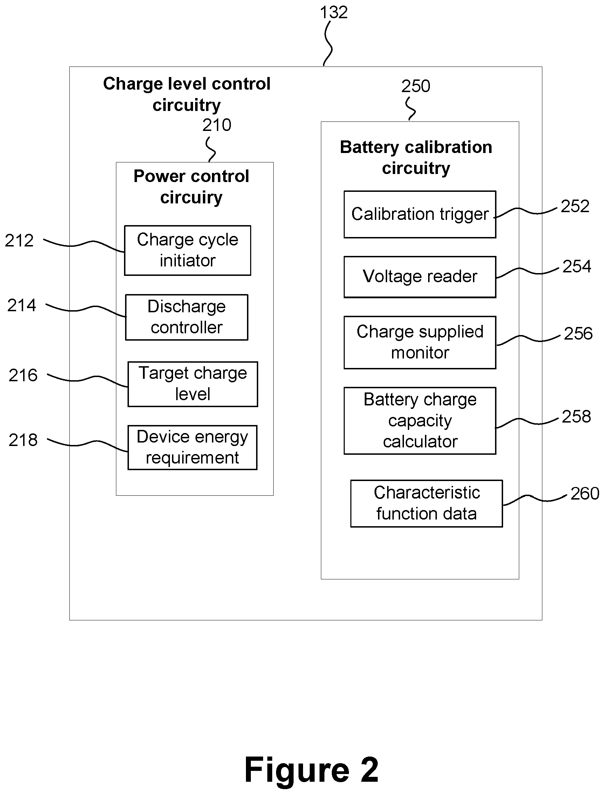

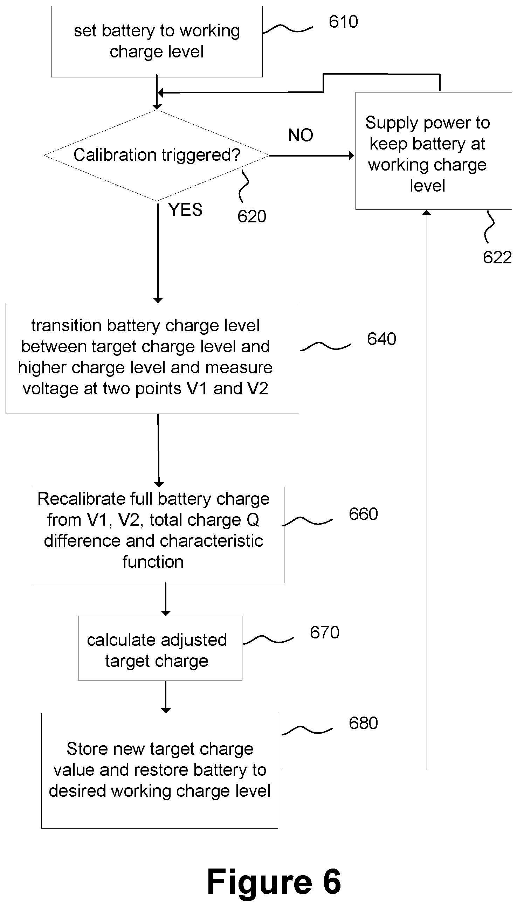

Figure 2 schematically illustrates an architecture of the charge level control circuitry 132 of Figure 1. The architecture may be implemented as machine-readable instructions, configurable hardware, special purpose hardware or any combination thereof and may perform at least the functionality of the flowchart of Figure 6 described below. The charge level control circuitry 210 comprises power control circuitry 210 and battery calibration circuitry 250.

The power control circuitry has a charge cycle initiator 212, a charge and discharge controller 214, a target charge level register 216 and a device energy requirement register 218.

The battery calibration circuitry 250 has a calibration trigger 252, a voltage reader 254, a charge supplied monitor 256, a battery charge capacity calculator 258 and stored characteristic function data 260.

Considering first the power control circuitry 210, the charge cycle initiator 212 may trigger a calibration cycle of the battery during which power is supplied to the battery from the power supply unit 150 via the I&V regulator 134. The charge cycle initiator 212 may be arranged to trigger a calibration cycle periodically according to a configurable time period, or alternatively, the calibration may be triggered intermittently or at least once. The intermittent triggering of calibration may be performed responsive to a user input or responsive to a change in operational conditions such as a detected battery temperature falling below above or below a threshold temperature. The charge and discharge controller 214 may be used to control charging and/or discharging of the battery 110 during a calibration event. If a controlled current and voltage is provided via the I&V regulator 134 when charging the battery from the target level to the calibration level , the discharge controller 214 can be used, although it may not be needed in some cases. Similarly, if a controlled discharge of the battery from the calibration level back down to a lower charge level, such as the target charge level, is performed, then the charge and discharge controller 214 could be used at the outset of the calibration to perform a controlled charge of the battery 110 up to the calibration level, although it may not be needed.

The target charge level register 216 stores a value that may be calculated depending on the device energy requirement 218, which may be stored in a memory. The device energy requirement 218 may have a fixed value whereas, the target charge level may be adjusted to meet the device energy requirement each time the battery is recalibrated. Where the target charge level is a dimensionless percentage charge level or a corresponding voltage value, as the battery 110 ages, to achieve a given device energy requirement, for example in Ah or Wh, the minimum percentage charge level of the battery required to satisfy the energy requirement is likely to progressively increase as the battery ages.

One example of a device energy requirement may be energy required at a given device power rating to keep the electronic device 160 for a given time at that rating to ensure a safe shutdown in the event of a mains power disruption. Another example, where the electronic device 160 is a server may be a requirement of sufficient energy to allow a system backup to be performed responsive to a power disruption event. Another example may be where the electronic device is a rescue robot or a drone, which may be deployed infrequently, where the device energy requirement 218 may be set based upon a power rating of the robot or drone and a typical deployment time for an individual deployment event.

Yet further examples may relate to a configurable minimum energy requirement for electric mobile devices or electric vehicles, for which it is desirable to keep battery charge at a non-zero charge level. It is undesirable to risk discharging an electronic vehicle down to say the range of 0 to 10% charge level for the purpose of calibration, because this could potentially result in a user's journey being disrupted unless the calibration is carefully timed.

The device energy requirement 218 may be calculated by an algorithm that predicts a user's usage pattern or behaviour, for example, based on at least one of historical usage data over a given time interval for the particular user or for a group of users and possibly based on demographic data etc. The energy requirement 218 calculated based on such a prediction may be updated as appropriate to increase or at least maintain an accuracy of the prediction. Alternatively, or in addition, triggering of a battery calibration event may depend upon the predicted usage pattern of the electronic device.

Considering next the battery calibration circuitry 250, the calibration trigger 252 is arranged to trigger a calibration event by invoking the charge cycle initiator 212 of the power control circuitry 212. The triggering of the calibration may be periodic, repeated at irregular time intervals or triggered responsive to one or more measurable factors that could cause variability in a desired target charge level of the battery. Examples of such measurable factors include battery temperature, battery impedance and peak power. In some examples, the calibration trigger may cause the discharge controller 214 to discharge the battery from a high charge level maintained between calibration events, down to but not below the target charge level.

The voltage reader 254 is arranged to measure a voltage of the battery for the purposes of calibration. Given a battery voltage reading, a characteristic function of the battery from the characteristic function data 260 may be used to obtain a corresponding battery capacity expressed as a percentage. The voltage measurements can provide an accurate value of maximum battery capacity when the voltage is measured with no load on the battery. The voltage measured by the voltage reader 254 may be, but is not limited to one of an open circuit voltage, a voltage under no current or a voltage under current with calibration. For example, one calibration of the voltage measurement may be performed according to at least one of the following formulae:

$$V_{OC} = V_{MEAS} + (R_{BAT} \times I_{DISCHARGE}) \quad ..... \quad [equation\ 1]$$

$$V_{OC} = V_{MEAS} - (R_{BAT} \times I_{CHARGE}) \quad ..... \quad [equation\ 2]$$

Where $V_{OC}$ is an open circuit voltage, $V_{MEAS}$ is a measured voltage, $R_{BAT}$ is resistance of the battery, $I_{DISCHARGE}$ is a discharge current and $I_{CHARGE}$ is a charge current.

A usable battery capacity may be less than a battery capacity based upon an open circuit voltage due to the energy expended to overcome the internal resistance (or impedance) of the battery. An average value of battery resistance may be used in the above equations to convert between an open circuit voltage and a voltage under current. In some examples adjustments to the estimated battery resistance may be made depending upon at least one of the battery temperature, the battery age and the battery state of charge when the voltage measurement is made.

The charge supplied monitor 256 is arranged to measure, during a charging cycle of a calibration event, a total charge in Coulombs passed from the power supply unit to the battery 110 to take the battery from a lower voltage, greater than or equal to the target voltage, to a higher voltage. Alternatively, or in addition, the charge supplied monitor 256 may be used to measure, during a discharging calibration cycle, a total charge in Coulombs passing via the current integrator 119 to bring the battery from a calibration voltage down to a lower voltage.

The battery charge capacity calculator 258 uses voltage measurements made by the voltage reader 254 and the integrated current (total charge) determined by the charge supplied monitor 256 and makes reference to the characteristic function data 260 to perform a calibration of a charge level of a battery in a dimensioned unit such as Coulombs or Ah. The characteristic function data 260 may be stored in memory local to the battery calibration circuitry 250 or alternatively may be accessed remotely by the battery calibration circuitry 250.

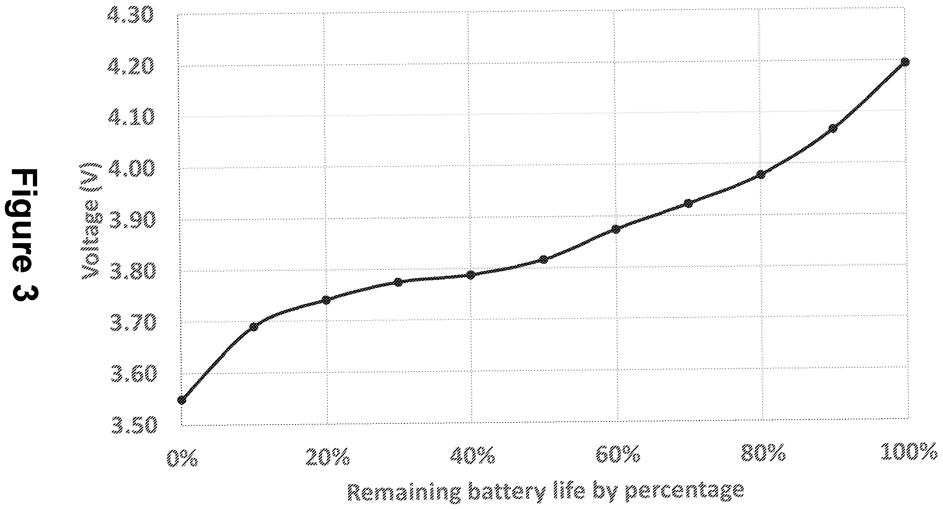

Figure 3 schematically illustrates one example of a characteristic function of a battery that may be implemented as the characteristic function data 260 of the battery calibration circuitry 250 of Figure 2. Figure 3 is a graph of voltage against remaining battery life as a percentage for a particular battery. The remaining battery capacity expressed as a percentage is a dimensionless quantity, although, values of battery capacity in Ah can be mapped onto the percentage values based on, for example, an up-to-date estimate of a full battery capacity. A new battery may have a manufacturer-specified maximum capacity, which would correspond to the 100% remaining battery life. However, as the battery degrades over time, the actual maximum capacity is likely to decline relative to the manufacturer-specified maximum. Thus a remapping of dimensioned values of battery capacity to the percentage values of the x-axis of the graph of Figure 3 may be appropriate. This is why the calibration (recalibration) is performed. Some properties of a battery are invariant with regard to the age of the battery.

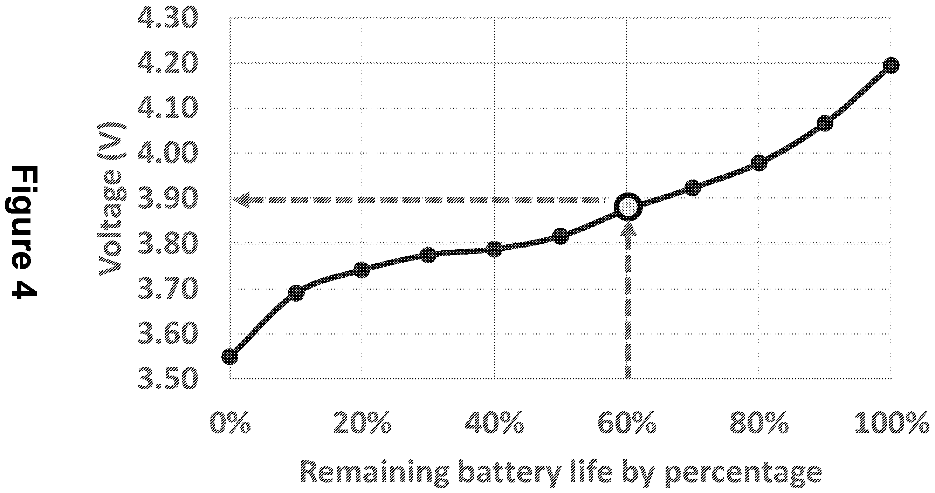

The graph of Figure 3 is one example of a relationship between two battery characteristics that is expected to be invariant over time, or at least invariant with regard to a degradation over time of the maximum battery capacity in Ah (or an alternative dimension). Thus, regardless of the age of the battery, a 60% remaining charge for the battery whose chemistry is characterized by Figure 3, should result in a battery voltage reading of 3.9V for the battery to which the characteristic function relates. This data point of 60% remaining battery life corresponding to 3.9V is shown in Figure 4 for an identical characteristic function to that illustrated in Figure 3. By way of contrast, a graph of voltage against battery capacity in Ah would be expected to vary with battery age. Different battery types are likely to have different characteristic functions. The example of Figure 3 relates to a Li-ion battery, but different batteries may have different characteristic functions, depending upon, for example, differences in battery chemistry.

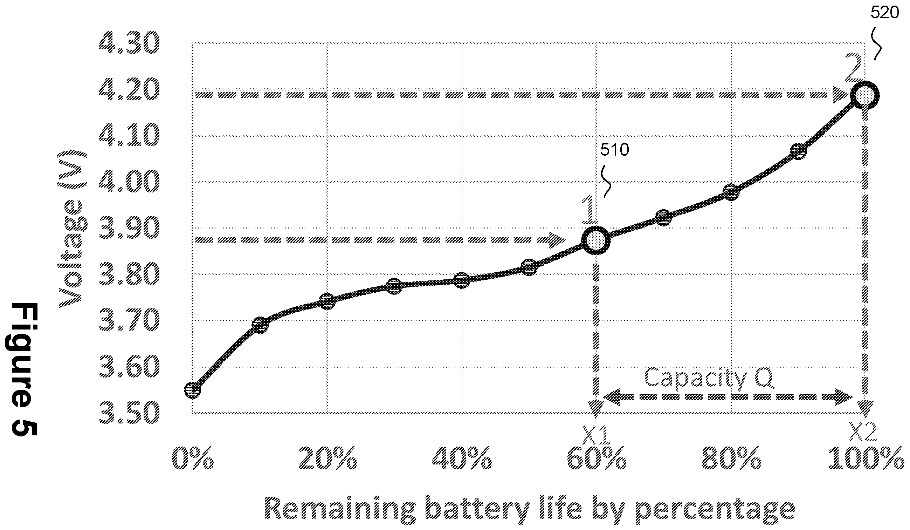

Figure 5 schematically illustrates data points on the characteristic function graph of Figure 3 for an example battery calibration involving two calibration points, X1 510 and X2 520. In Figure 5, the first calibration point 510 corresponds to a target charge level at the beginning of the calibration, which is 60% of remaining battery life (point X1 on the x-axis of Figure 5) and corresponds to a voltage of just below 3.9V on the characteristic function of the battery. The second calibration point 520 corresponds to a higher charge level than the first data point, denoted a "calibration charge level", at which the battery has been charged to 100% of its full capacity (point X2 on the x-axis) and corresponding to a voltage of 4.2V. In other examples the calibration charge level may be less than 100% of capacity on the x-axis, but is greater than the target charge level, which depends on the device energy requirement. The example calibration process of Figure 5 is as follows:

i. Charge the fresh battery to the target charge level (X1 in Figure 5) to meet an energy requirement (e.g. a backup time) for the associated electronic device. The target charge level may be but is not limited to an energy in Watt-hours (1Wh=3600J) that safe equipment shutdown takes or data backup of a server takes. In the Figure 5 example, a backup time is 60Wh, based on a fresh battery capacity of 100Wh.

ii. Keep the battery at percentage charge X1 during operation, by providing power from the power supply unit 150 (of Figure 1) if appropriate to maintain the target charge level. This extends longevity of the battery. Alternatively, during operation, the battery may be maintained at a level higher than the target level and may be discharged to no less than the target level to perform the calibration. In a further alternative the operational charge level is higher than the target level and the calibration level is higher again than the operational level.

iii. Periodically (or intermittently or at least once) charge the battery to the calibration charge level X2. In examples where the operational charge level is higher than the target charge level (such as at least 10% greater), the charging step may be omitted because the calibration can be performed via a partial discharge.

iv. Read battery voltage values from the y-axis of the characteristic function graph (Figure 5) of point X1, corresponding to graph point 510, and point X2, corresponding to graph point 520, and read a corresponding charge percentage of each voltage by referring to the graph (or equivalent stored data such as a table representing the same characteristic function) that shows the relationship between voltage and remaining charge percentage.

v. Monitor the total charge in Coulombs ($Q_{total}$) passed from power supply unit 150 to elevate the battery from the charge percentage point X1 until the point X2. Alternatively, monitor charge flowing out of battery when it is discharged from X2 to X1.

vi. Calculate the battery full charge capacity, $Q_{full\ charge}$ , of the degraded battery by the following equation:

$$Q_{full\ charge} = \left(\frac{100}{(X2-X1)}\right) \times Qtotal \ \ \dots\dots \text{[equation 3]}$$

Where capacities $Q_{full\ charge}$ and $Q_{total}$ may be expressed in Ah (Coulombs) or Wh (Joules).

vii. Recalculate the target charge level X1' based on the calibration result above and keep the battery at new X1' during operation or at a higher charge level if desired. The new target charge level is saved and used at least to specify a minimum calibration point in a subsequent calibration event. For example, if the required backup time is 60Wh and the new $Q_{full\ charge}$ is 90 Wh, where it was originally 100Wh, then the X1'= (60/90)%= 67% of remaining battery life.

The monitoring of total charge in Coulombs ($Q_{total}$) passed from power supply unit 150 to transition the battery between the charge percentage point X1 and the point X2 may be equivalent to determining a difference in magnitude of charge between percentage point X1 and percentage point X2. In the example of Figure 5, the calibration is performed by elevating the battery charge level from the target level up to 100% of battery capacity by supplying charge from the power supply unit 150. However, in alternative examples, the calibration charge level may be less than 100%, but greater than the target charge level at which the battery calibration begins. An elevation of, for example, 10% may be sufficient to provide an accurate estimate of $Q_{full\ charge}$ of a *degraded (or* partially degraded battery). The calibration may be performed to measure $Q_{total}$ between any two points on the graph of Figure 5 provided that the calibration does not involve discharging the battery below the starting target charge level. This avoids potentially compromising the available battery capacity in case there should be a requirement for backup power during a calibration event. The first charge level X1, may be greater than or equal to the target charge level at the beginning of the calibration event. A greater difference in magnitude between the X1 and X2 may provide a more accurate calibration, although setting X2 to a 100% charge level could potentially cause more damage to the battery and thus accelerate degradation of $Q_{total}$. By appropriately setting X1 and X2, a balance may be achieved between performing an accurate calibration and yet ensuring that backup power is available even if required during a calibration event and reducing any potential damage to the battery by repeatedly charging up to or close to 100% remaining capacity.

Figure 6 is a flowchart that schematically illustrates how the arrangement of Figure 1 performs battery calibration. The process starts at element 610 where a battery is set to a working charge level. In some examples the working charge level is the target charge level, although it may be higher. For a fresh battery, the target charge level may be based on a manufacturer specified maximum battery capacity and the target charge level maybe based on, for example an energy amount in Watt hours representing a time at a certain power rating to ensure safe shutdown of the associated electronic device (such as a server) without data loss. Another example of the target charge level may correspond to a typical energy requirement for a deployment of an electronic device such as a robot or a drone, the deployment potentially being made between charging sessions. The target charge level may alternatively correspond to a battery-preserving charge level that provides sufficient power for a predicted use pattern of the electronic device whilst was reducing the likely degradation of the battery capacity over time, which can result from repeatedly charging the battery up to 100% capacity. Although in some examples a fresh battery is considered at element 710, a previously used battery may alternatively be deployed at process element 710, provided that the full charge capacity is established at the outset and that the initial target charge level is appropriately the set when the battery is initially deployed based upon energy requirements of the device.

At process element 620 it is determined whether or not a calibration event to determine full battery capacity should be triggered. Depending upon implementation, the calibration may be triggered periodically according to a period that may be pre-set or user-configurable, or may be automatically triggered intermittently depending on, for example, a threshold number of deployments of a backup battery. In yet further alternative examples, the calibration may be triggered manually by user as and when required. If it is determined at process element 620 that no calibration has been triggered then the process proceeds to element 622 where power is supplied, if appropriate, from the power supply unit 150 to keep the battery at the working charge level as set at element 610. It may be that no supply of power is necessary to keep the battery at this level, but this will depend upon the particular deployment scenario.

If, on the other hand, at process element 620 it is determined that a calibration has been triggered then the process proceeds to element 640, where the battery charge level is transitioned between the target charge level and a higher charge level and where two voltage readings V1 and V2 are made at two different calibration points, . It may be convenient to measure V1 at the target charge level where the working charge level is equal to the target charge level and to measure V2 at a calibration charge level at or close to 100% charge, such as point X2 520 in the Figure 5 graph. This provides a good range over which to perform the calibration, which may improve accuracy. In alternative examples V1 and V2 may be measured at any selected different points on the x-axis of the characteristic curve of Figure 5, provided that the points are separated and that both points are greater than or equal to the percentage charge corresponding to the target charge level. The measurements at the calibration points may be made on a charging trajectory or on a discharge trajectory of the characteristic curve. In some examples measurements at two points on each of the charging trajectory and the discharging trajectory may be made and the four points may be used to provide a more accurate value. The set of points on the charging trajectory may be at different x-axis values than the set of points on the discharge trajectory. On the charging trajectory $Q_{total}$ may correspond to total charge supplied via a charging current. On the discharge trajectory $Q_{total}$ may correspond to a total charge flowing out of the battery via a discharge current.

The voltage measurements V1 and V2 may be open circuit or closed circuit voltage measurements as described in relation to [equation 1] and [equation 2] above. To ensure that available battery power is not compromised as a result of the calibration event, the voltage of the battery is raised above the target voltage level to a calibration voltage level that is greater than the target voltage level, rather than performing a calibration by discharging the battery.

Next, at process element 660, the full battery charge is recalibrated with reference to the characteristic function of Figures 3 to 5 and using [equation 3] together with the measured value of the total charge input required to transition the battery between the two different voltage levels V1 and V2, or equivalently between the two different percentages of full charge available. The value of $Q_{total}$ is determined using calculated the current integrator 119 of Figure 1, which is some examples is a Coulomb gauge.

At process element 670 an adjusted target charge level appropriate to the degraded battery full capacity is calculated and subsequently at process element 680 the battery is restored to a desired working charge level. In some examples the working charge level is the recalibrated target charge level calculated at process element 670, although it may be higher. The adjusted target charge level calculated at process element 670 is stored at least for use in a subsequent calibration event to set a lowest charge level on the x-axis of the characteristic function to which the battery may be discharged. The process then returns from element 680 back to element 622, where the battery is maintained at the working charge level pending a next calibration event.

In examples where the working charge level of the battery is set to be higher than the target charge level, the calibration may be performed by discharging the battery to a lower charge level corresponding to no less than the target charge level calculated based upon the device energy requirement. In some such examples, there may be a desire to replace a battery when it has reached a threshold value of, say 80% of a fresh battery capacity. Calibration according to the present technique may be used in this case to determine an appropriate time to replace the battery taking account of degradation of battery capacity with time. Once the degraded full charge of the battery is determined via calibration involving a discharge of the battery down to no less than the target charge level, it can be determined based on an energy requirement of the device whether or not replacement of the battery is appropriate. After the calibration event, if it is determined that replacement of the battery is not appropriate, then the battery may be recharged to a higher percentage of remaining charge than the target charge level if desired. In this case, similarly to the example of Figure 6, a calibration may be performed between the points X1 (voltage V1) and X2 (voltage V2) (or equivalent calibration points) on a charging trajectory of the characteristic curve of Figure 5 or on a discharge trajectory or by averaging measurements on a charging trajectory and on a discharge trajectory.

In this specification, the phrase "at least one of A or B" should be interpreted to mean any one or more of the plurality of listed items, taken jointly and severally in any and all permutations.

Where functional units have been described as circuitry, the circuitry may be general purpose processor circuitry configured by program code to perform specified processing functions. The circuitry may also be configured by modification to the processing hardware. Configuration of the circuitry to perform a specified function may be entirely in hardware, entirely in software or using a combination of hardware modification and software execution. Program instructions may be used to configure logic gates of general purpose or special-purpose processor circuitry to perform a processing function.

Circuitry may be implemented, for example, as a hardware circuit comprising custom Very Large Scale Integrated, VLSI, circuits or gate arrays, off-the-shelf semiconductors such as logic chips, transistors, or other discrete components. Circuitry may also be implemented in programmable hardware devices such as field programmable gate arrays, FPGA, programmable array logic, programmable logic devices, A System on Chip, SoC, or the like.

Machine readable program instructions may be provided on a transitory medium such as a transmission medium or on a non-transitory medium such as a storage medium. Such machine readable instructions (computer program code) may be implemented in a high level procedural or object oriented programming language. However, the program(s) may be implemented in assembly or machine language, if desired. In any case, the language may be a compiled or interpreted language, and combined with hardware implementations.

## Claims

1. Charge level control circuitry (132) to control a charge level of a battery, the charge level control circuitry comprising:

    power management circuitry to connect a power supply to control a charge level of the battery;
    battery calibration circuitry (250) to control the power management circuitry to temporarily transition a charge level of the battery between a target charge level, and a calibration charge level, greater than the target charge level, wherein the target charge level is set to meet an energy requirement of an electronic device to which the battery is to supply power,
    wherein the battery calibration circuitry is further configured to:

    measure a total difference in magnitude of charge between a first charge level, greater than or equal to the target charge level and a second charge level, greater than the first charge level;
    determine a first battery voltage corresponding to the first charge level and a second battery voltage corresponding to the second charge level from a characteristic function of the battery, wherein a battery charge capacity value is calculated based on the first battery voltage, the second battery voltage, and the total difference in magnitude of charge.

2. Charge level control circuitry (132) as claimed in claim 1, wherein temporarily transitioning the battery comprises charging the battery to transition from at least the target charge level to the calibration charge level or discharging the battery to transition from the calibration charge level to no less than the target charge level.

3. Charge level control circuitry (132) as claimed in claim 1 or claim 2, wherein the power control circuitry is to maintain the battery at a charge level set based upon the target charge level between calibration events.

4. Charge level control circuitry (132) as claimed in any one of claims 1 to 3, wherein at least one of: the first charge level is equal to the target charge level prior to a battery calibration event; or the second charge level is equal to the calibration charge level of the same battery calibration event.

5. Charge level control circuitry (132) as claimed in any one of claims 1 to 4, wherein the battery calibration circuitry comprises a current integrator to measure the total charge magnitude difference resulting from power supplied to the battery to change the battery from the first charge level to the second charge level or to measure the total charge magnitude difference when power is being drained from the battery to change the battery from the second charge level to the first charge level.

6. Charge level control circuitry (132) as claimed in any one of claims 1 to 5, wherein the battery is a backup battery to supply backup power to the electronic device in the event of a disruption to a main power supply and wherein the energy requirement relates to a backup time to provide resilience of the device to the mains power disruption.

7. Charge level control circuitry (132) as claimed in any one of claims 1 to 6, wherein the characteristic function of the battery is a functional relationship between a battery voltage and a dimensionless battery charge level, the characteristic function being invariant to a degradation in battery charge capacity with time.

8. An integrated circuit or System on Chip, SoC, comprising the charge level control circuitry of any one of claims 1 to 7.

9. A battery assembly for an electronic device comprising:

a battery; and
charge level control circuitry according to any of claims 1 to 7.

10. The battery assembly of claim 9, wherein the battery charge capacity value is calculated using a total charge difference between at least two calibration points on the characteristic curve between the calibration charge level and the target charge level and using a dimensionless ratio representing a difference in battery charge remaining between the two calibration points.

11. A battery operated system comprising:

an electronic device;
a battery to supply power to the electronic device; and
charge level control circuitry according to any of claims 1 to 7.

12. The battery operated system as claimed in claim 11, wherein the power control circuitry is to maintain the battery, between successive calibration events, at a charge level corresponding to the target charge level as adjusted depending upon a most recently calculated battery full-charge capacity.

13. Machine-readable instructions provided on at least one machine-readable medium, the machine-readable instructions, when executed by the charge level control circuitry of any of claims 1 to 7, to cause the charge level control circuitry to:

set a target charge level of a battery to satisfy an energy requirement of an electronic device to which the battery is to supply power;
perform a battery calibration by transitioning a charge level of the battery between the target charge level and a calibration charge level, greater than the target charge level;
measure a total difference in magnitude of charge between a first charge level, greater than or equal to the target charge level and a second charge level, greater than the first charge level;
determine a first battery voltage corresponding to the first charge level and a second battery voltage corresponding to the second charge level from a characteristic function of the battery;
calculate a calibrated full battery charge capacity based on the first battery voltage, the second battery voltage, and the total difference in magnitude of charge; and
adjust the target charge level to meet the energy requirement based upon the calibrated full battery charge capacity.

**Patentansprüche**

1. Ladezustand-Steuerschaltung (132) zur Steuerung des Ladezustands einer Batterie, wobei die Ladezustand-Steuerschaltung Folgendes umfasst:

   eine Energieverwaltungschaltung zum Anschließen einer Stromversorgung zur Steuerung des Ladezustands der Batterie;
   eine Batteriekalibrierungsschaltung (250), um die Energieverwaltungsschaltung so zu steuern, dass ein Ladezustand der Batterie vorübergehend zwischen einem Zielladezustand und einem Kalibrierungsladezustand, der größer als der Zielladezustand ist, übergeht, wobei der Zielladezustand so eingestellt ist, dass er einen Energiebedarf eines elektronischen Gerätes deckt, das von der Batterie mit Energie versorgt werden soll,
   wobei die Batteriekalibrierungsschaltung ferner für Folgendes ausgelegt ist:

   Messen einer Gesamtdifferenz in der Ladungsgröße zwischen einem ersten Ladezustand, der größer oder gleich dem Zielladezustand ist, und einem zweiten Ladezustand, der größer als der erste Ladezustand ist;
   Bestimmen einer ersten Batteriespannung, die dem ersten Ladezustand entspricht, und einer zweiten Batteriespannung, die dem zweiten Ladezustand entspricht, aus einer charakteristischen Funktion der Batterie, wobei ein Batterieladekapazitätswert auf der Grundlage der ersten Batteriespannung, der zweiten Batteriespannung und der Gesamtdifferenz in der Größe der Ladung berechnet wird.

2. Ladezustand-Steuerschaltung (132) nach Anspruch 1, wobei der vorübergehende Übergang der Batterie das Laden der Batterie zum Übergang von mindestens dem Zielladezustand auf den Kalibrierungsladezustand oder das Entladen der Batterie zum Übergang vom Kalibrierungsladezustand auf nicht weniger als den Zielladezustand umfasst.

3. Ladezustand-Steuerschaltung (132) nach Anspruch 1 oder 2, wobei die Leistungssteuerschaltung die Batterie zwischen den Kalibrierungsereignissen auf einem Ladezustand halten soll, der auf der Grundlage des Zielladezustands eingestellt ist.

4. Ladezustand-Steuerschaltung (132) nach einem der Ansprüche 1 bis 3, wobei mindestens einer des ersten Ladezustands oder des zweiten Ladezustands gleich dem Zielladezustand vor einem Batteriekalibrierungsereignis bzw. gleich dem Kalibrierungsladezustand desselben Batteriekalibrierungsereignisses ist.

5. Ladezustand-Steuerschaltung (132) nach einem der Ansprüche 1 bis 4, wobei die Batteriekalibrierungsschaltung einen Stromintegrator umfasst, um die Gesamtladungsgrößendifferenz zu messen, die sich aus der der Batterie zugeführten Leistung ergibt, um die Batterie von dem ersten Ladezustand auf den zweiten Ladezustand umzuschalten, oder um die Gesamtladungsgrößendifferenz zu messen, wenn der Batterie Leistung entzogen wird, um die Batterie von dem zweiten Ladezustand auf den ersten Ladezustand umzuschalten.

6. Ladezustand-Steuerschaltung (132) nach einem der Ansprüche 1 bis 5, wobei die Batterie eine Pufferbatterie ist, um das elektronische Gerät im Falle einer Unterbrechung der Hauptstromversorgung mit Pufferstrom zu versorgen, und wobei sich der Energiebedarf auf eine Pufferzeit bezieht, um das Gerät gegenüber der Unterbrechung der Hauptstromversorgung unempfindlich zu machen.

7. Ladezustand-Steuerschaltung (132) nach einem der Ansprüche 1 bis 6, wobei die charakteristische Funktion der Batterie eine funktionale Beziehung zwischen einer Batteriespannung und einem dimensionslosen Batterieladezustand ist, wobei die charakteristische Funktion gegenüber einer Verschlechterung der Batterieladekapazität mit der Zeit invariant ist.

8. Integrierte Schaltung oder System on Chip (SoC), die Ladezustand-Steuerschaltung nach einem der Ansprüche 1 bis 7 umfassend.

9. Batterieanordnung für ein elektronisches Gerät, die Folgendes umfasst:

   eine Batterie; und
   eine Ladezustand-Steuerschaltung gemäß einem der Ansprüche 1 bis 7.

10. Batterieanordnung nach Anspruch 9, wobei der Batterieladekapazitätswert unter Verwendung einer Gesamtladungsdifferenz zwischen mindestens zwei Kalibrierungspunkten auf der Kennlinie zwischen dem Kalibrierungsladezustand und dem Zielladezustand und unter Verwendung eines dimensionslosen Verhältnisses berechnet wird, das eine Differenz der zwischen den beiden Kalibrierungspunkten verbleibenden Batterieladung darstellt.

11. Batteriebetriebenes System, das Folgendes umfasst:

ein elektronisches Gerät;
eine Batterie zur Stromversorgung des elektronischen Gerätes; und
eine Ladezustand-Steuerschaltung gemäß einem der Ansprüche 1 bis 7.

12. Batteriebetriebenes System nach Anspruch 11, wobei die Leistungssteuerschaltung dazu dient, die Batterie zwischen aufeinanderfolgenden Kalibrierungsereignissen auf einem Ladezustand zu halten, der dem Zielladezustand entspricht, der in Abhängigkeit von der zuletzt berechneten vollen Ladekapazität der Batterie eingestellt wurde.

13. Maschinenlesbare Anweisungen, die auf mindestens einem maschinenlesbaren Medium bereitgestellt werden, wobei die maschinenlesbaren Anweisungen, wenn sie von der Ladezustand-Steuerschaltung nach einem der Ansprüche 1 bis 7 ausgeführt werden, die Ladezustand-Steuerschaltung zu Folgendem veranlassen:

Einstellen eines Zielladezustands einer Batterie, um den Energiebedarf eines elektronischen Gerätes zu decken, das von der Batterie mit Strom versorgt werden soll;
Durchführen einer Batteriekalibrierung, indem ein Ladezustand der Batterie zwischen dem Zielladezustand und einem Kalibrierungsladezustand, der größer als der Zielladezustand ist, übergeht;
Messen einer Gesamtdifferenz in der Ladungsgröße zwischen einem ersten Ladezustand, der größer oder gleich dem Zielladezustand ist, und einem zweiten Ladezustand, der größer als der erste Ladezustand ist;
Bestimmen einer ersten Batteriespannung, die dem ersten Ladezustand entspricht, und einer zweiten Batteriespannung, die dem zweiten Ladezustand entspricht, aus einer charakteristischen Funktion der Batterie;
Berechnen einer kalibrierten vollen Batterieladekapazität auf der Grundlage der ersten Batteriespannung, der zweiten Batteriespannung und der Gesamtdifferenz in der Größe der Ladung; und
Anpassen des Zielladezustands, dass der Energiebedarf auf der Grundlage der kalibrierten vollen Batterieladekapazität gedeckt wird.


**Revendications**

1. Circuits de commande de niveau de charge (132) pour commander un niveau de charge d'une batterie, les circuits de commande de niveau de charge comprenant :

des circuits de gestion d'énergie pour connecter une alimentation électrique pour commander un niveau de charge de la batterie ;
des circuits d'étalonnage de batterie (250) pour commander les circuits de gestion d'énergie pour faire passer temporairement un niveau de charge de la batterie d'un niveau de charge cible à un niveau de charge d'étalonnage, plus grand que le niveau de charge cible, et inversement, le niveau de charge cible étant défini pour répondre à un besoin en énergie d'un dispositif électronique auquel la batterie est destinée à fournir de l'énergie, les circuits d'étalonnage de batterie étant en outre configurés pour :

mesurer une différence totale d'amplitude de charge entre un premier niveau de charge, plus grand ou égal au niveau de charge cible et un deuxième niveau de charge, plus grand que le premier niveau de charge ;
déterminer une première tension de batterie correspondant au premier niveau de charge et une deuxième tension de batterie correspondant au deuxième niveau de charge à partir d'une fonction caractéristique de la batterie, une valeur de capacité de charge de batterie étant calculée sur la base de la première tension de batterie, de la deuxième tension de batterie, et de la différence totale d'amplitude de charge.

2. Circuits de commande de niveau de charge (132) selon la revendication 1, faire passer la batterie temporairement d'un niveau de charge à un autre comprenant la charge de la batterie pour passer d'au moins le niveau de charge cible au niveau de charge d'étalonnage ou la décharge de la batterie pour passer du niveau de charge d'étalonnage à pas moins que le niveau de charge cible.

3. Circuits de commande de niveau de charge (132) selon la revendication 1 ou la revendication 2, les circuits de commande d'énergie étant destinés à maintenir la batterie à un niveau de charge défini sur la base du niveau de charge cible entre des événements d'étalonnage.

4. Circuits de commande de niveau de charge (132) selon l'une quelconque des revendications 1 à 3, le premier niveau de charge étant égal au niveau de charge cible avant un événement d'étalonnage de batterie et/ou le deuxième niveau de charge étant égal au niveau de charge d'étalonnage du même événement d'étalonnage de batterie.

5. Circuits de commande de niveau de charge (132) selon l'une quelconque des revendications 1 à 4, les circuits d'étalonnage de batterie comprenant un intégrateur de courant pour mesurer la différence d'amplitude de charge totale résultant d'une énergie fournie à la batterie pour changer la batterie du premier niveau de charge au deuxième niveau de charge ou pour mesurer la différence d'amplitude de charge totale lorsque de l'énergie est prélevée de la batterie pour changer la batterie du deuxième niveau de charge au premier niveau de charge.

6. Circuits de commande de niveau de charge (132) selon l'une quelconque des revendications 1 à 5, la batterie étant une batterie de secours pour fournir de l'énergie de secours au dispositif électronique dans l'éventualité d'une coupure d'une alimentation électrique secteur, et le besoin en énergie étant lié à une durée de secours pour assurer une résilience du dispositif face à la coupure d'alimentation secteur.

7. Circuits de commande de niveau de charge (132) selon l'une quelconque des revendications 1 à 6, la fonction caractéristique de la batterie étant une relation fonctionnelle entre une tension de batterie et niveau de charge de batterie sans dimension, la fonction caractéristique étant invariante face à une dégradation de capacité de charge de batterie avec le temps.

8. Circuit intégré ou système sur puce, SoC, comprenant les circuits de commande de niveau de charge selon l'une quelconque des revendications 1 à 7.

9. Ensemble de batterie pour un dispositif électronique comprenant :

une batterie ; et
des circuits de commande de niveau de charge selon l'une quelconque des revendications 1 à 7.

10. Ensemble de batterie selon la revendication 9, la valeur de capacité de charge de batterie étant calculée en utilisant une différence de charge totale entre au moins deux points d'étalonnage sur la courbe caractéristique entre le niveau de charge d'étalonnage et le niveau de charge cible et en utilisant un rapport sans dimension représentant une différence de charge de batterie restante entre les deux points d'étalonnage.

11. Système fonctionnant sur batterie comprenant :

un dispositif électronique ;
une batterie pour fournir de l'énergie au dispositif électronique ; et
des circuits de commande de niveau de charge selon l'une quelconque des revendications 1 à 7.

12. Système fonctionnant sur batterie selon la revendication 11, les circuits de commande d'énergie étant destinés à maintenir la batterie, entre des événements d'étalonnage successifs, à un niveau de charge correspondant au niveau de charge cible ajusté en fonction d'une capacité de pleine charge de batterie calculée le plus récemment.

13. Instructions lisibles par machine fournies sur au moins un support lisible par machine, les instructions lisibles par machine, lorsqu'elles sont exécutées par les circuits de commande de niveau de charge selon l'une quelconque des revendications 1 à 7, amenant les circuits de commande de niveau de charge à :

définir un niveau de charge cible d'une batterie pour répondre à un besoin en énergie d'un dispositif électronique auquel la batterie est destinée à fournir de l'énergie ;
réaliser un étalonnage de batterie en faisant passer un niveau de charge de la batterie du niveau de charge cible à un niveau de charge d'étalonnage, plus grand que le niveau de charge cible, et inversement ;
mesurer une différence totale d'amplitude de charge entre un premier niveau de charge, plus grand ou égal au niveau de charge cible et un deuxième niveau de charge, plus grand que le premier niveau de charge ;
déterminer une première tension de batterie correspondant au premier niveau de charge et une deuxième tension de batterie correspondant au deuxième niveau de charge à partir d'une fonction caractéristique de la batterie ;

calculer une capacité de charge de batterie pleine étalonnée sur la base de la première tension de batterie, de la deuxième tension de batterie, et de la différence totale d'amplitude de charge ; et

ajuster le niveau de charge cible pour répondre au besoin en énergie sur la base de la capacité de charge de batterie pleine étalonnée.

**Figure 1**

**Figure 2**

**Figure 3**

**Figure 4**

**Figure 5**

**Figure 6**

**EP 3 602 724 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2016189832 A1